# EUROPEAN PATENT SPECIFICATION

(11) **EP 2 158 292 B1**
(45) Date of publication and mention of the grant of the patent: **15.02.2012**
(21) Application number: 08754201.5
(22) Date of filing: 02.05.2008
(51) Int. Cl.: C09K 11/79, C09K 11/64

(54) **SINGLE CRYSTAL PHOSPHOR LIGHT CONVERSION STRUCTURES FOR LIGHT EMITTING DEVICES**
MONOKRISTALLINE PHOSPHORLICHTKONVERSIONSKONSTRUKTION FÜR LICHTEMITTIERENDE VORRICHTUNG
STRUCTURES DE CONVERSION DE LUMIÈRE DE LUMINOPHORE MONOCRISTALLIN POUR DES DISPOSITIFS ÉMETTANT DE LA LUMIÈRE

(30) Priority: 16.05.2007 US 749258
(43) Date of publication of application: 03.03.2010
(73) Proprietor: Cree, Inc., Durham, NC 27703 (US)
(72) Inventor: LETOQUIN, Ronan, P., Durham, NC 27713 (US); MEDENDORP, Nicholas, W., Jr., Raleigh, NC 27614 (US); KELLER, Bernd, P., Santa Barbara, CA 93111 (US); CHAKRABORTY, Arpan, Goleta, CA 93117 (US)
(74) Representative: Cross, Rupert Edward Blount
(86) International application number: PCT/US2008/005694
(87) International publication number: WO 2008/143773

(56) References cited:
- EP-A- 1 555 307
- EP-A- 1 696 016
- WO-A-2006/073141
- US-A1- 2004 062 699
- US-A1- 2005 051 790
- US-A1- 2006 076 569

## Description

### FIELD OF THE INVENTION

This invention relates to solid state light emitting devices and fabrication methods therefor, and more particularly, to light conversion structures used in solid state light emitting devices.

### BACKGROUND OF THE INVENTION

Light emitting diodes and laser diodes are well known solid state lighting elements capable of generating light upon application of a sufficient voltage. Light emitting diodes and laser diodes may be generally referred to as light emitting devices ("LEDs"). Light emitting devices generally include a p-n junction formed in an epitaxial layer grown on a substrate such as sapphire, silicon, silicon carbide, gallium arsenide and the like. The wavelength distribution of the light generated by the LED generally depends on the material from which the p-n junction is fabricated and the structure of the thin epitaxial layers that make up the active region of the device

It is often desirable to incorporate phosphor into a solid state light emitting device to enhance the emitted radiation in a particular frequency band and/or to convert at least some of the radiation to another frequency band. The term "phosphor" may be used herein to refer to any materials that absorb light at one wavelength and re-emit light at a different wavelength, regardless of the delay between absorption and re-emission and regardless of the wavelengths involved. Accordingly, the term "phosphor" may be used herein to refer to materials that are sometimes called fluorescent and/or phosphorescent. In general, phosphors absorb light having shorter wavelengths and re-emit light having longer wavelengths. As such, some or all of the light emitted by the LED at a first wavelength may be absorbed by the phosphor particles, which may responsively emit light at a second wavelength. For example, a single blue emitting LED may be surrounded with a yellow phosphor, such as cerium-doped yttrium aluminum garnet (YAG). The resulting light, which is a combination of blue light and yellow light, may appear white to an observer.

While many phosphors are known and used by those of skill in the art, there remains a need for phosphor materials and processes that improve quantum efficiency and facilitate the manufacturing of solid state light emitting devices that include phosphor.

US-2006/076569 describes a semiconductor light emitting device having a light emitting element and a silicate phosphor. WO-2006/073141 relates to an oxynitride phosphor.

### SUMMARY OF THE INVENTION

The present invention provides a solid state light emitting device according to claim 1. Provided according to some embodiments are solid state light emitting devices that include a solid state light emitting die and a light conversion structure. The solid state light emitting die is configured to emit light upon energization thereof. The light conversion structure includes a single crystal phosphor and may be on a light emitting surface of the solid state light emitting die. In some embodiments, the light conversion structure is attached to the light emitting surface via an adhesive layer, which, in some embodiments, includes a silicone polymer. Furthermore, in some embodiments, the light conversion structure may be sized to fit a light emitting surface of the solid state light emitting die. In some embodiments, the light conversion structure may be directly on a light emitting surface of the solid state light emitting die. In addition, in some embodiments, the light conversion structure may act as a substrate for a solid state light emitting die.

A phosphor material that may be grown as a single crystal may be used in light conversion structures according to some embodiments of the invention. For example, cerium-doped single crystal phosphors, such as Ce:YAG, Ce:(Ca, Mg, Sr)AlSiN3 and/or Ce:SrGaS, may be used. As another example, europium-doped single crystal phosphors, such as Eu:(Ca, Sr)AlSiN3, Eu:Sr2-xBaxSi04, Eu:SrGaS, Eu:[alpha]-SiAlON and europium-doped silicon garnet, may be used.

According to some embodiments of the invention, the single crystal phosphor light conversion structure may be texturized, roughened, etched and/or featured.

Also provided according to the present invention is a method of fabricating a solid state light emitting device according to claim 14. In some embodiments, methods of fabricating solid state light emitting devices include placing a light conversion structure comprising a single crystal phosphor on a light emitting surface of a solid state light emitting die. The placing of the light conversion structure may include adhesively attaching a light conversion structure comprising a single crystal phosphor to the light emitting surface of the solid state light emitting die, according to some embodiments of the invention. The placing of the light conversion structure may also include growing a single crystal phosphor on the surface of the solid state light emitting die via a single crystal thin film deposition technique, according to other embodiments of the invention.

Furthermore, provided according to some embodiments are methods of fabricating solid state light emitting devices that include growing a solid state light emitting die on a surface of a light conversion structure that includes a single crystal phosphor. In some embodiments, the surface of the light conversion structure is polished before the solid state light emitting die is grown thereon.

### BRIEF DESCRIPTION OF THE DRAWINGS

FIGS. 1A-1F are cross-sectional views of various configurations of conventional light emitting diodes.
FIG. 1G is a cross-sectional view of a conventional packaged light emitting diode.
FIGS. 2A-2F are cross-sectional views of solid state light emitting devices according to various embodiments of the present invention during intermediate fabrication thereof.
FIGS. 3A-3F are cross-sectional views of solid state light emitting devices after attachment of the single crystal phosphor light conversion structure, according to various embodiments of the present invention.
FIG. 3G is a cross-sectional view of a packaged device of FIG. 3F, according to various embodiments of the present invention.
FIGS. 3H-3M are cross-sectional views of solid state light emitting devices after attachment of the single crystal phosphor light conversion structure, according to various embodiments of the present invention.
FIG. 3N is a cross-sectional view of a packaged device of FIG. 3M, according to various embodiments of the present invention.
FIG. 4 is a flowchart of operations that may be performed to fabricate solid state light emitting devices according to various embodiments of the present invention.
FIGS. 5A and 5B are cross-sectional views of packaged devices according to various embodiments of the present invention.
FIGS. 6A-6F are cross-sectional views of solid state light emitting devices according to other embodiments of the present invention.
FIGS. 7A-7F are cross-sectional views of solid state light emitting devices according to yet other embodiments of the present invention.
FIGS. 8A-8F are cross-sectional views of solid state light emitting devices according to still other embodiments of the present invention.
FIGS. 9A-9F are cross-sectional views of solid state light emitting devices according to further embodiments of the present invention.
FIGS. 10A and 10B are cross-sectional views of solid state light emitting devices according to various embodiments of the present invention during intermediate fabrication thereof.
FIG. 11 is a flowchart of operations that may be performed to fabricate a single crystal light conversion structure according to various embodiments of the present invention.
FIG. 12 is a cross-sectional view of a large area preform that is configured to attach to multiple solid state light emitting dice according to various embodiments of the present invention.
FIGS. 13 is a flowchart of operations that may be performed to fabricate solid state light emitting devices according to various embodiments of the present invention.
FIG. 14 is a flowchart of operations that may be performed to fabricate solid state light emitting devices according to various embodiments of the present invention.
FIG. 15 is a schematic illustration of a display unit having a backlight including a light emitting device according to some embodiments of the invention.
FIG. 16 is a schematic illustration of a solid state luminaire including a light emitting device according to some embodiments of the invention.

### DETAILED DESCRIPTION OF EMBODIMENTS OF THE INVENTION

The invention will be described more fully hereinafter with reference to the accompanying drawings, in which example embodiments of the invention are shown. This invention may, however, be embodied in many different forms and should not be
construed as limited to the example embodiments set forth herein. Rather, the disclosed embodiments are provided so that this disclosure will be thorough and complete. In the drawings, the size and relative sizes of layers and regions may be exaggerated for clarity. Moreover, each embodiment described and illustrated herein includes its complementary conductivity type embodiment as well. Like numbers refer to like elements throughout.

It will be understood that when an element or layer is referred to as being "on," "connected to," "coupled to" or "responsive to" (and/or variants thereof) another element, it can be directly on or directly connected, coupled or responsive to the other element or intervening elements may be present. In contrast, when an element is referred to as being "directly on," "directly connected to," "directly coupled to" or "directly responsive to" (and/or variants thereof) another element, there are no intervening elements present. Like numbers refer to like elements throughout. As used herein, the term "and/or" includes any and all combinations of one or more of the associated listed items and may be abbreviated as "/".

It will be understood that, although the terms first, second, third, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "comprises" and/or "comprising" (and/or variants thereof), when used in this specification, specify the presence of stated features, integers, steps, operations, elements, and/or components, but do not preclude the presence or addition of one or more other features, integers, steps, operations, elements, components, and/or groups thereof. In contrast, the term "consisting of" (and/or variants thereof) when used in this specification, specifies the stated number of features, integers, steps, operations, elements, and/or components, and precludes additional features, integers, steps, operations, elements, and/or components.

The present invention is described below with reference to block diagrams and/or flowchart illustrations of methods and/or apparatus (systems) according to embodiments of the invention. It is understood that a block of the block diagrams and/or flowchart illustrations, and combinations of blocks in the block diagrams and/or flowchart illustrations, can embody apparatus/systems (structure), means (function) and/or steps (methods) for implementing the functions/acts specified in the block diagrams and/or flowchart block or blocks.

It should also be noted that in some alternate implementations, the functions/acts noted in the blocks may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated.

Furthermore, relative terms, such as "lower" or "bottom" and "upper" or "top," may be used herein to describe one element's relationship to another elements as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower", can therefore, encompasses both an orientation of "lower" and "upper," depending of the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Example embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, may be expected. Thus, the disclosed example embodiments of the invention should not be construed as limited to the particular shapes of regions illustrated herein unless expressly so defined herein, but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the invention, unless expressly so defined herein.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and the present application, and will not be interpreted in an idealized or overly formal sense unless expressly so defined herein.

According to some embodiments of the present invention, provided are solid state light emitting devices that include a solid state light emitting die that is configured to emit light upon energization thereof and a single crystal phosphor light conversion structure on a light emitting surface of the solid state light emitting die. In some embodiments, the single crystal phosphor light conversion structure may be formed on the light emitting surface of the solid state die by thin film vapor deposition technique, such as MOCVD, MBE, LPE, and the like, as described in further detail below. In other embodiments, the single crystal phosphor may be grown externally (*e.g*., via a Czochralksi-type method), which may also be referred to as a preform, optionally sized to fit the light emitting surface of the die, and then attached to the light emitting surface, as described in further detail below. The single crystal phosphor preform may be adhesively attached to the light emitting die in some embodiments. Furthermore, in some embodiments, the light conversion structure may act as a substrate for the solid state light emitting die.

A "single crystal phosphor light conversion structure" is a structure in an LED that includes a single crystal phosphor that may absorb light at one wavelength and re-emit light at another wavelength. In some embodiments, the single crystal phosphor light conversion structure consists of a single crystal phosphor.

The phrase "adhesively attaching" means bonding two elements to one another. The bonding may be direct via a single adhesive layer or via one or more intermediate adhesive and/or other layers/structures, to form a unitary structure of the solid state light emitting die and the single crystal phosphor preform that is adhesively attached thereto, such that this unitary structure may be placed on a submount or other packaging element.

Finally, the term "transparent" means that optical radiation from the solid state light emitting device can pass through the material without being totally absorbed or totally reflected.

The use of a single crystal phosphor light conversion structure, according to various embodiments of the invention, may provide many potential advantages in the fabrication of solid state light emitting devices. For example, it is often desirable to incorporate phosphor and/or other optical elements into the solid state light emitting device. However, when coating a phosphor layer, the coating may be unduly thick and/or undesirably nonuniform. Moreover, a phosphor layer that is incorporated into a dome or shell also may be too thick and/or nonuniform. In addition, currently, phosphors are generally provided to the LED as a polycrystalline powder, wherein the size and quality of the phosphor particles may significantly affect the quantum efficiency of the phosphor. In addition, the phosphor particles may be applied to the chip in silicone or other polymeric matrix. The correlated color temperature (CCT) of the light emitted from the phosphor particles may be altered by varying the quantity of the phosphor particles in the polymer matrix, or by varying the thickness of the polymer matrix. However, it may be difficult to cut, shape and/or handle some polymeric light conversion structures in order to place them accurately on the chip. Furthermore, although the polymer is only present in the light conversion structure to act as an inert matrix for the phosphor particles, its absorption may become an issue if relatively thick preforms are used. Thus, in practice, relatively thin structures may be used, which may result in handling difficulties, especially in mass production.

The single crystal phosphor light conversion structure may be formed from any suitable phosphor material that may be grown as a single crystal. For example, the single crystal phosphor material may be a cerium (Ce) doped single crystal, such as Y₃Al₅O₁₂ (Ce:YAG), in some embodiments. In other embodiments, other phosphors, such as Ce and/or europium (Eu) doped (Ca, Sr, Mg)AlSiN₃; Eu doped Sr₂₋ₓBaₓSiO₄ (BOSE); Ce or Eu doped strontium thio-gallate; or Eu doped alpha-SiAlON, Y₂O₂S, La₂O₂S, silicon garnet, Y₂O₂S or La₂O₂S may be used. In addition, in some embodiments, the phosphors described in European Patent Publication No. 1,696,016, U.S. Patent Publication No. 2007/0075629 and U.S. Patent Application No. (Attorney Docket No. 5308-727), entitled *Cerium and Europium-Doped Phosphor Compositions and Light Emitting Devices Including the Same,* filed on (Inventor: Ronan P. Le Toquin) may also be used. The single crystal phosphor may also be doped at any suitable level. In some embodiments, Ce and/or Eu is doped into the single crystal phosphor such that the dopant concentration is in a range of about 0.1 to about 20%.

Since light conversion structures of the invention are formed from a single crystal phosphor, the index of refraction may be increased relative to traditionally used light conversion structures due to the relatively high index of refraction of the phosphor. Extraction efficiency through the relatively high index of refraction single crystal phosphor light conversion structure may thereby be enhanced. Moreover, in some embodiments, the single crystal phosphor light conversion structure may be relatively thin, for example, in a range of about 10 nm to about 200 µm, and in other embodiments, in a range of about 10 µm to 200 µm, and in some embodiments, in a range of about 15 µm to about 35 µm. In addition, in some embodiments, the single crystal film may have a thickness on the order of yellow wavelength of light (500 to 600nm), which may introduce resonance into the single crystal phosphor and enhance light extraction. Internal absorption or bounce seen in polymeric light conversion structures may also be reduced by using a single crystal phosphor light conversion structure. Also, in some embodiments, the single crystal phosphor light conversion structure is a preform that can be formed separately from the solid state light emitting die, and so it can be fabricated and tested without impacting the reliability and/or yield of the solid state light emitting die. Finally, the relatively rigid single crystal phosphor may allow for more efficient and effective texturization, roughening, etching and/or featuring of the light conversion structure.

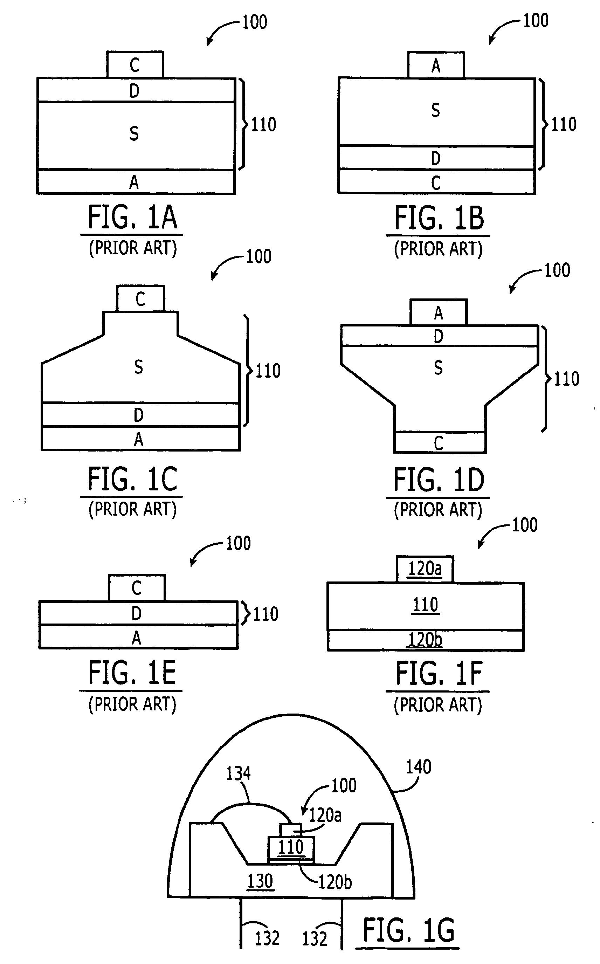

Figures 1A-1E are cross-sectional views of various configurations of conventional light emitting diodes (LEDs) that may be used with single crystal phosphor light conversion structures, optionally in combination with other optical elements, according to various embodiments of the present invention. As shown in Figures 1A-1E, a solid state light emitting device **100** includes a solid state light emitting die **110** that may comprise a diode region **D** and a substrate **S.** The diode region **D** is configured to emit light upon energization thereof, by applying a voltage between an anode contact **A** and a cathode contact **C.** The diode region **D** may comprise organic and/or inorganic materials. In inorganic devices, the substrate **S** may comprise silicon carbide, sapphire and/or any other single element and/or compound semiconductor material, and the diode region **D** may comprise silicon carbide, gallium nitride, gallium arsenide, zinc oxide and/or any other single element or compound semiconductor material, which may be the same as or different from the substrate **S.** The substrate **S** may be between about 100 µm and about 250 µm thick, although thinner and thicker substrates may be used or the substrate may not be used at all. The cathode **C** and anode **A** contacts may be formed of metal and/or other conductors, and may be at least partially transparent and/or reflective. The design and fabrication of organic and inorganic LEDs are well known to those having skill in the art and need not be described in detail herein. LEDs such as depicted in Figures 1A-1E may be marketed by Cree, Inc., the assignee of the present application, for example under the designators XThin^{®}, MegaBright^{®}, EZBright^{™}, UltraThin^{™}, RazerThin^{®}, XBright^{®}, XLamp^{®} and/or other designators, and by others.

In Figure 1A, light emission may take place directly from the diode region **D.** In contrast; in embodiments of Figure 1B, emission may take place from diode region **D** through the substrate S. In Figures 1C and 1D, the substrate S may be shaped to enhance emission from sidewalls of the substrate **S** and/or to provide other desirable effects. Finally, in Figure 1E, the substrate itself may be thinned considerably or eliminated entirely, so that only a diode region **D** is present. Moreover, in all of the above embodiments, the anode **A** and cathode **C** contacts may be of various configurations and may be provided on opposite sides of the solid state light emitting die **110,** as illustrated, or on the same side of the solid state light emitting die **110.** Multiple contacts of a given type also may be provided.

Figure 1F provides a generalization of Figures 1A-1E, by providing a solid state light emitting device **100** that comprises a solid state light emitting die **110** that includes a diode region **D** of Figures 1A-1E and also may include substrates of Figures 1A-1E, and that is configured to emit light upon energization thereof via one or more contacts **120a, 120b,** which may include the anode **A** and cathode **C** of Figures 1A-1E.

Figure 1G illustrates a solid state light emitting device **100** of Figure 1F that is packaged by mounting the device **100** on the submount **130** that provides external electrical connections **132** using one or more wire bonds **134** and also provides a protective dome or cover **140.** Many other packaging techniques may be
employed to package a solid state light emitting die, as is well known to those having skill in the art, and need not be described further herein. For example, packaging techniques are described in U.S. Patent Nos. 6,791,119, issued September 14, 2004 to Slater, Jr. et al., entitled *Light Emitting Diodes Including Modifications for Light Extraction*; 6,888,167, issued May 3, 2005 to Slater, Jr. et al., entitled *Flip-Chip Bonding of Light Emitting Devices and Light Emitting Devices Suitable for Flip-Chip Bonding*; 6,740,906, issued May 24, 2004 to Slater, Jr. et al., entitled *Light Emitting Diodes Including Modifications for Submount Bonding*; 6,853,010, issued February 8, 2005 to Slater, Jr. et al., entitled *Phosphor-Coated Light Emitting Diodes Including Tapered Sidewalls, and Fabrication Methods Therefor*; 6,885,033, issued April 26, 2005 to Andrews, entitled *Light Emitting Devices for Light Conversion and Methods and Semiconductor Chips for Fabricating the Same*; and 7,029,935, issued April 18, 2006 to Negley et al., entitled *Transmissive Optical Elements Including Transparent Plastic Shell Having a Phosphor Dispersed Therein, and Methods of Fabricating Same*; U.S. Patent Application Publications Nos. 2005/0051789, published March 10, 2005 to Negley et al., *Solid Metal Block Mounting Substrates for Semiconductor Light Emitting Devices, and Oxidizing Methods for Fabricating Same;* 2005/0212405, published September 29, 2005 to Negley, *Semiconductor Light Emitting Devices Including Flexible Film Having Therein an Optical Element, and Methods of Assembling Same*; 2006/0018122, published January 26, 2006 to Negley, *Reflective Optical Elements for Semiconductor Light Emitting Devices*; 2006/0061259, published March 23, 2006 to Negley, *Semiconductor Light Emitting Devices Including Patternable Films Comprising Transparent Silicone and Phosphor, and Methods of Manufacturing Same*; 2006/0097385, published May 11, 2006 to Negley, *Solid Metal Block Semiconductor Light Emitting Device Mounting Substrates and Packages Including Cavities and Heat Sinks, and Methods of Packaging Same;* 2006/0124953, published June 15, 2006 to Negley et al., *Semiconductor Light Emitting Device Mounting Substrates and Packages Including Cavities and Cover Plates, and Methods of Packaging Same*; and 2006/0139945, published June 29, 2006 to Negley et al., *Light Emitting Diode Arrays for Direct Backlighting of Liquid Crystal Displays*; and U.S. Application Serial Number 11/408,767, filed April 21, 2006 for Villard, *Multiple Thermal Path Packaging For Solid State Light Emitting Apparatus And Associated Assembling Methods*, all assigned to the assignee of the present invention, the disclosures of which are hereby incorporated herein by reference in their entirety as if set forth fully herein.

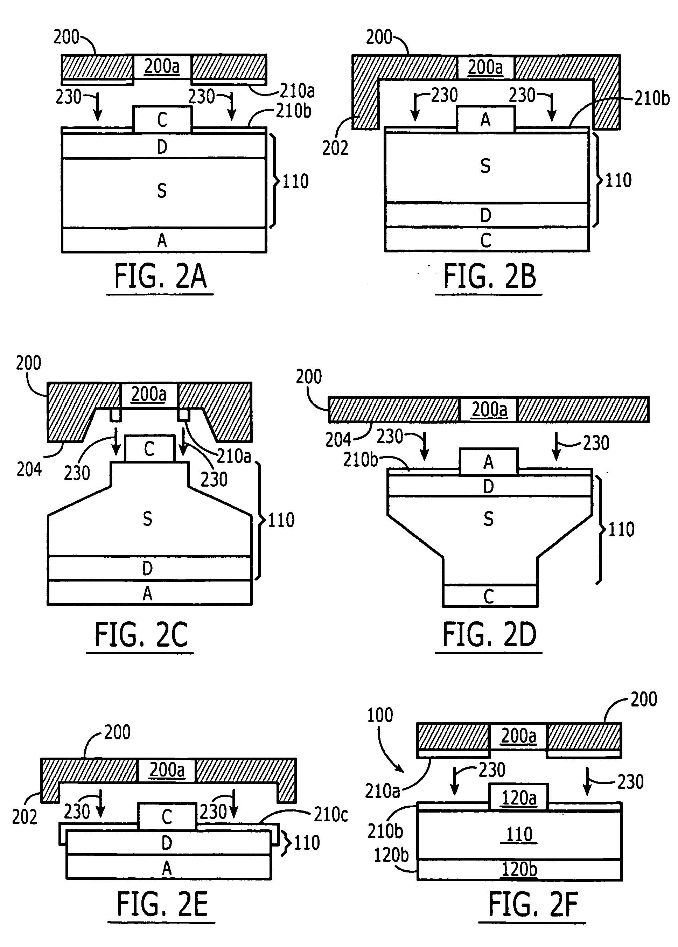

Figures 2A-2F are cross-sectional views, according to various embodiments of the present invention, of the intermediate fabrication of a solid state light emitting device including a single crystal phosphor light conversion structure that is grown externally and then attached to the solid state light emitting device (also referred to herein as a "preform"). The respective solid state light emitting devices of Figures 2A-2F employ the respective solid state light emitting dice of Figures 1A-1F. As described below, the single crystal phosphor light conversion structure may be optionally modified, e.g., by cutting, polishing, texturing, and the like, before or after being attached to the solid state light emitting die.

As shown in Figure 2A, a single crystal phosphor light conversion structure **200** is sufficiently thin so as to allow at least some light that is emitted from the solid state light emitting die **110** to pass therethrough. A layer **210a, 210b,** such as an adhesive layer, also may be provided on the single crystal phosphor light conversion structure **200** and/or on the die **110** that attaches, such as adhesively attaches, the single crystal phosphor light conversion structure **200** and the solid state light emitting die **110** to one another as shown by arrows **230** and also optically couples the single crystal phosphor light conversion structure **200,** and the solid state light emitting die **110** to one another. The single crystal phosphor light conversion structure **200** is an optical element that can modify at least some of the light that is emitted from the solid state light emitting die **110.** As described below, other optical elements may be used in combination with the single crystal phosphor light conversion structure **200** according to some embodiments of the invention. It will also be understood that, in some embodiments, the layer **210a, 210b** may be provided only on the single crystal phosphor light conversion structure **200** or only on the die **110.** The layer **210a, 210b** may be transparent epoxy, such as a thermoset silicone gel or rubber, that is available from Dow Corning, Shin-Etsu, NuSil, GE and others, and/or any other transparent epoxy.

As also shown in Figure 2A, the single crystal phosphor light conversion structure **200** may relatively rigid compared to silicone-based light conversion structures. In some embodiments, the single crystal phosphor light conversion structure may be the approximate size of a face of an LED die, for example about 1000 µm × 1000 µm, and may have a thickness of between about 1 µm and about 100 µm. However, other dimensions may be provided in other embodiments.

As also shown in Figure 2A, the solid state light emitting die may include an external contact pad, such as cathode **C,** and the single crystal phosphor light conversion structure **200** may include a notch, hole and/or other void **200a** that is configured so as to expose the external contact pad **C.** In embodiments of Figure 2A, the single crystal phosphor light conversion structure **200** is planar and may be of uniform thickness. Moreover, the single crystal phosphor light conversion structure **200** of Figure 2A may be of same size and shape as a surface of the solid state light emitting die **110,** except for a void, notch or other surface feature **200a** that may be provided to expose an external contact **C.** It may also be desirable to provide one or more features in the single crystal phosphor light conversion structure to facilitate alignment of the single crystal phosphor light conversion structure **200** to the die **110.**

Figure 2B illustrates other embodiments of the present invention, wherein the single crystal phosphor light conversion structure **200** is nonplanar and may include, for example, a sidewall **202** that is configured to extend along a sidewall of the solid state light emitting die **110.** Radiation that is emitted from the sidewall of the solid state light emitting die may thereby pass through the single crystal phosphor light conversion structure **200,** as well as radiation that is emitted from the major surface to which the single crystal phosphor light conversion structure **200** is attached. The sidewall **202** may extend partway or fully along the sidewall of the die. Moreover, in some embodiments, the single crystal phosphor light conversion structure **200** may extend all the way around the die, including on the sidewalls and the opposing faces of the die. The layer **210b** may be located on the die as shown in Figure 2B, and may also be provided on the single crystal phosphor light conversion structure **200** including on the sidewall **202** of the single crystal phosphor light conversion structure **200** and/or on the sidewall of the die **110.**

Figure 2C illustrates other embodiments of the present invention, wherein the single crystal phosphor light conversion structure extends beyond a surface of the die **110.** Accordingly, as shown in Figure 2C, the single crystal phosphor light conversion structure **200** overhangs a surface of the solid state light emitting die **110.** By providing an overhang, radiation from a sidewall of the device may pass through the single crystal phosphor light conversion structure **200.** As also shown in Figure 2C, the overhang **204** may be thicker than the remaining portion of the single crystal phosphor light conversion structure **200.** Moreover, the overhang **204** may extend a large distance beyond the die and may extend to a sidewall of a cavity in which the die **110** is mounted, so that substantially all light that is emitted from the cavity passes through the single crystal phosphor light conversion structure **200.**

Figure 2D illustrates other embodiments, wherein a uniform thickness single crystal phosphor light conversion structure **200** may include an overhang **204.** Again, the overhang **204** may extend a large distance beyond the die and may extend to a sidewall of a cavity in which the die **110** is mounted, so that substantially all light that is emitted from the cavity passes through the single crystal phosphor light conversion structure. Figure 2E illustrates the use of a single crystal phosphor light conversion structure of Figure 2B along with coupling/adhesive layer **210c** that extends along the sidewall of the LED die **110,** as well as on the top surface thereof. Finally, Figure 2F generically illustrates the use of a single crystal phosphor light conversion structure **200** and a coupling/adhesive layer **210a/210b** that attaches the single crystal phosphor light conversion structure **200** and a light emitting die to one another, as shown by arrows **230** and couples the single crystal phosphor light conversion structure **200** and the light emitting die **110** to one another. It will be understood by those having skill in the art that embodiments of Figures 2A-2F may be combined in various permutations and combinations. Thus, for example, a single crystal phosphor light conversion structure of Figure 2D may be used with the solid state light emitting die of Figure 2C and a single crystal phosphor light conversion structure of Figure 2E may be used with a solid state light emitting die of Figure 2D.

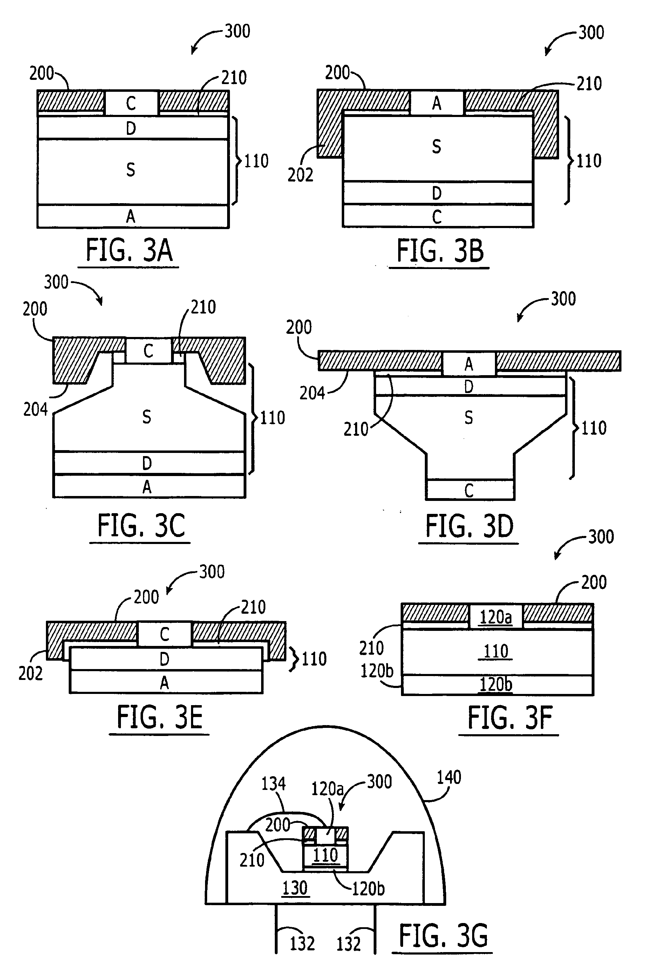

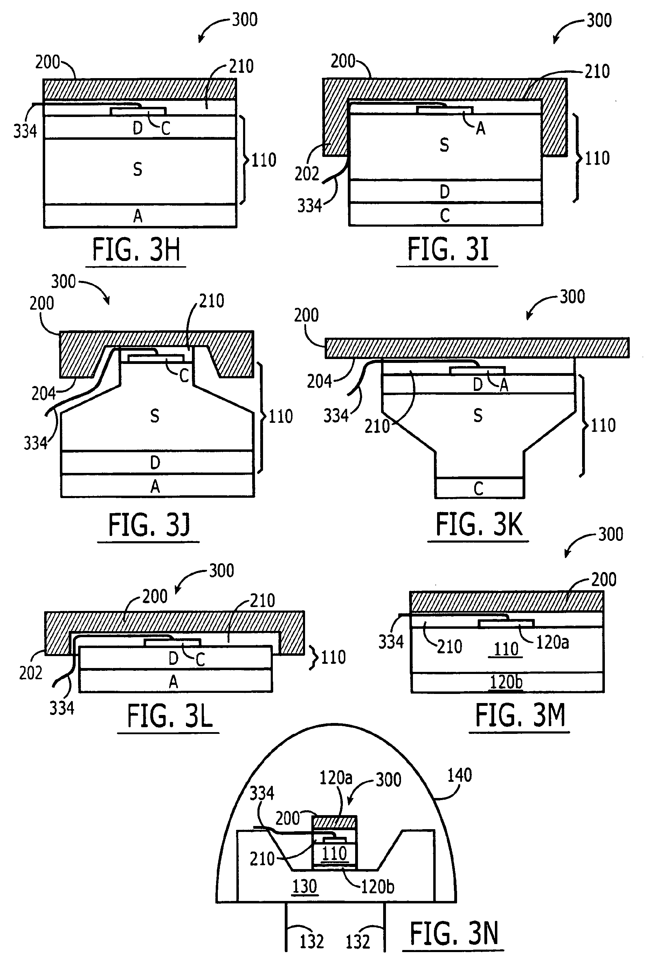

Figures 3A-3F correspond to Figures 2A-2F, but illustrate the single crystal phosphor light conversion structure **200** attached to the light emitting die **110** by a layer **210** that may comprise a coupling/adhesive layer **210a** and/or **210b** of Figure 2A. Accordingly, after attachment of the single crystal phosphor light conversion structure **200** and die **110,** a unitary structure **300** of the solid state light emitting die **110** and the single crystal phosphor light conversion structure **200** is provided. This unitary structure **300** may then be mounted on a submount **130** and further packaged, as shown in Figure 3G.

Figures 3H-3N correspond to Figures 3A-3G, but illustrate the use of a low profile wire bond **33**4 that does not pass through the single crystal phosphor light conversion structure **200** itself but, rather, passes through the layer **210.** In these embodiments, the wire **334** may be bonded to the anode **A** or cathode **C,** before placing the adhesive/coupling layer **210** and the single crystal phosphor light conversion structure **200** on the die **110.** Low profile wire bonding embodiments of Figures 3H-3N may obviate the need for a cutout in the single crystal phosphor light conversion structure **200,** which can facilitate fabrication of the LEDs and can make alignment of the single crystal phosphor light conversion structure easier during assembly. Moreover, in these embodiments, it may be desirable to provide a thicker layer **210** to accommodate the wire **334** therein. Thicknesses of between about 35 µm and about 70 µm may be used in some embodiments of the present invention.

The layer **210** may be a liquid epoxy, as described above. The liquid epoxy may be dispensed onto the single crystal phosphor light conversion structure **200** and/or solid state light emitting die **110** prior to attachment of the single crystal phosphor light conversion structure **200** to the die **110,** and then cured after attachment of the single crystal phosphor light conversion structure **200** to the die **110.** For example, the above-described silicone-based liquid epoxy may be dispensed at room temperature and spread using the pick and place force of the single crystal phosphor light conversion structure **200** placement. Curing may then take place by heating in an oven. Adhesive layers of thickness of about 0.1 µm to about 50 µm may be used in some embodiments. Moreover, in other embodiments, a "wicking" adhesive/optical coupling fluid may be applied after placing the single crystal phosphor light conversion structure **200** on the die **110,** to provide a thin layer **210.**

Single crystal phosphor light conversion structures may be configured, as was illustrated in Figures 2A-2F and 3A-3N, to provide various potential advantages according to some embodiments of the invention. For example, in Figures 2B, 2E, 3B, 3E, 3I and 3L, the single crystal phosphor light conversion structure **200** includes a sidewall **202** that extends at least partially along or adjacent a sidewall of the solid state light emitting die **110.** It has been found, according to some embodiments of the present invention that, although light may be primarily emitted from the top surface of the die **110,** some low angle sidewall emission may take place. This sidewall emission may adversely impact the desired Correlated Color Temperature (CCT) uniformity of the solid state light emitting device. However, by providing a three-dimensional (nonplanar) single crystal phosphor light conversion structure **200,** side emissions may also be "captured" by the single crystal phosphor light conversion structure **200.** Back emissions may also be captured, in some embodiments, by providing the single crystal phosphor light conversion structure on the opposing faces and the sidewalls of the die.

In another example, as illustrated in Figures 2C, 2D, 3C, 3D, 3J and 3K, the single crystal phosphor light conversion structure may include an overhang **204** that is the same thickness as, or is of different thickness than, the remainder of the single crystal phosphor light conversion structure **200.** The overhang **204** may capture radiation that is emitted from the sidewall of the solid state light emitting die **110.** Moreover, by providing a thicker overhang, the single crystal phosphor light conversion structure can convert, for example, a non-Lambertian radiation pattern to a more desirable Lambertian radiation pattern or can convert a somewhat Lambertian radiation pattern to a more Lambertian radiation pattern, in some embodiments. It will be understood by those having skill in the art that the thicker portions of the single crystal phosphor light conversion structure of Figures 2C, 3C and 3J may extend toward the solid state light emitting die **110** as shown in Figures 2C, 3C and 3J and/or away from the solid state light emitting die.

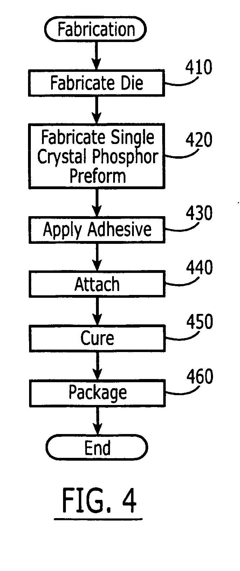

Figure 4 is a flowchart of operations that may be performed to fabricate solid state light emitting devices according to various embodiments of the present invention. Referring to Figure 4, at Block **410,** the solid state light emitting die, such as the die **110,** is fabricated using conventional techniques. At Block **420,** a single crystal phosphor light conversion structure, such as the single crystal phosphor light conversion structure **200,** is fabricated using techniques that will be described in detail below and/or using other single crystal phosphor light conversion structure fabrication techniques. It will be understood that the dice and single crystal phosphor light conversion structures may be fabricated out of the order shown in Figure 4 and/or at least partially overlapping in time.

Then, at Block **430,** adhesive, such as coupling/adhesive layer **210,** is applied to the die **110** and/or the single crystal phosphor light conversion structure 200. The single crystal phosphor light conversion structure and the die are then attached to one another at Block **440.** If needed, the adhesive is cured at Block **450.** Subsequent packaging may then take place at Block **460,** for example, by bonding the unitary structure of the die **110** and single crystal phosphor light conversion structure **200** to a submount and/or other packaging substrate. It will also be understood that a wire bond may be attached to the die before or after performing the attaching step at Block **440.**

While the single crystal phosphor light conversion structure can be extremely stable at high temperatures, and thus, can be put directly on or next to the light emitting surface, the efficiency of the single crystal phosphor is generally inversely related to the temperature of the single crystal phosphor light conversion structure **200.** The die **110** may be relatively warm, *e.g.*, at about 110 °C, and so raising or separating single crystal phosphor light conversion structure **200** from the die **110** may reduce or minimize heating of the single crystal phosphor light conversion structure **200,** thereby improving quantum efficiency.

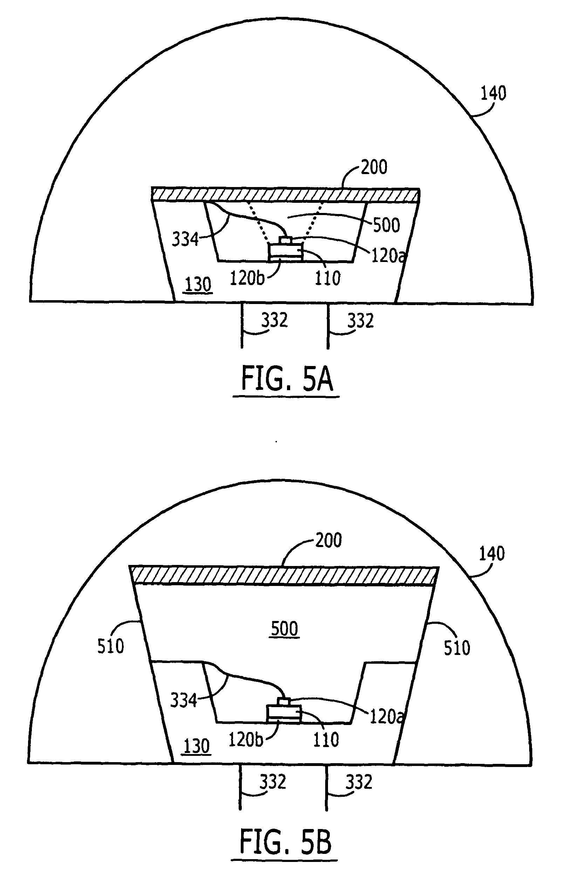

Referring to Figure 5A, according to some embodiments of the invention, the single crystal phosphor light conversion structure **200** is placed over the die **110** and on the submount **130,** whereby the single crystal phosphor light conversion structure **200** is attached to die **110** via a transparent substrate **500.** In other embodiments, the transparent substrate **500** is not present and so the single crystal phosphor light conversion structure **200** is not attached to the die **110** via the transparent substrate **500,** but instead an empty space is present between the die **110** and the single crystal phosphor light conversion structure **200.** Referring to Figure 5B, in some embodiments that may be referred to as "remote phosphor," the single crystal phosphor light conversion structure **200** may be raised above the submount **130** via sidewalls **510** and attached to the die **110** via a transparent substrate **500.** In some embodiments, the transparent substrate **500** is not present and so the single crystal phosphor light conversion structure **200** is not attached to the die **110** via a transparent substrate **500** but is supported by the sidewalls **510.** Thus, an empty space is provided between the die **110** and the single crystal phosphor light conversion structure **200.** The sidewalls **510** may be formed from a reflective surface (e.g., aluminum) and/or coated with a reflective material, in order to more efficiently irradiate the single crystal phosphor light conversion structure **200.** It will be understood that the distance between the die **110** and the single crystal phosphor light conversion structure **200** may be varied according to the configuration of the die **110,** submount **130** and transparent substrate **500.**

Many other optical elements may be provided in combination with the single crystal phosphor light conversion structure, according to various embodiments of the present invention. In general, the optical element may be configured to modify at least some of the light that is emitted from the solid state light emitting die **110,** by changing its amplitude, frequency and/or direction. These optical elements may include an additional light conversion structure including polycrystalline phosphor particles, an optical refracting element such as a lens, an optical filtering element such as a color filter, an optical scattering element such as optical scattering particles, an optical diffusing element such as a textured surface and/or an optical reflecting element such as a reflective surface, that is included in and/or on the single crystal phosphor light conversion structure. Combinations of these and/or other embodiments may be provided. Moreover, two or more single crystal phosphor light conversion structures may be provided, wherein each single crystal phosphor light conversion structure can perform a different optical processing function, the same optical processing function or overlapping processing functions, depending upon the desired functionality of the solid state light emitting device. Many other examples will now be described in detail.

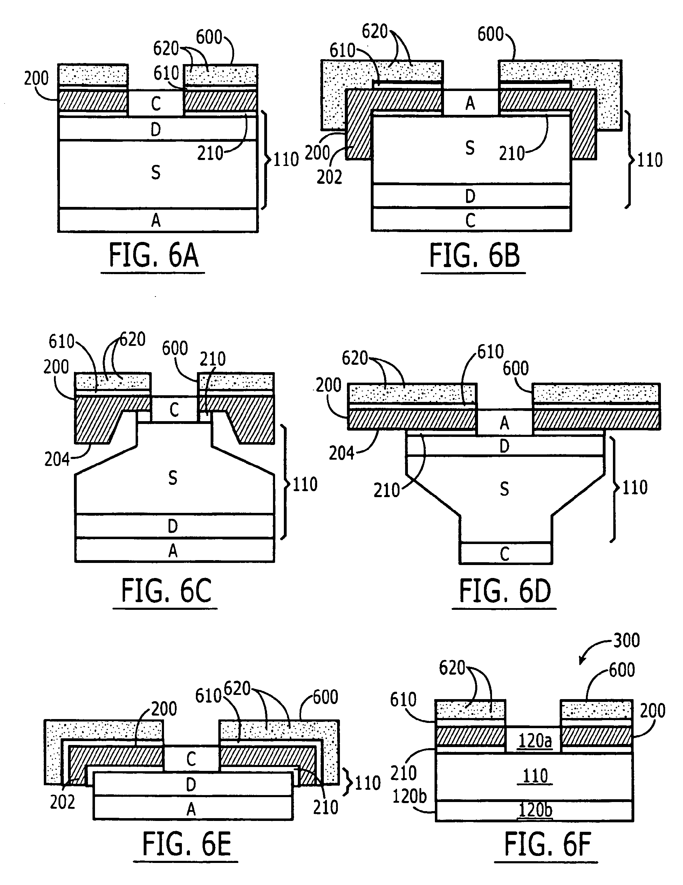

For example, as shown in Figures 6A-6F, a second light conversion structure **600** that includes scattering particles **620** therein may be attached/coupled by a second layer **610,** to separate the functionalities of light conversion and light scattering into two different light conversion structures **200, 600.** The second layer **610** may be the same as, or different from, the first layer **210.** It will be understood that the order of the first and second light conversion structures **200** and **600** relative to the solid state light emitting die **110** may be reversed from that shown in Figures 6A-6F. Moreover, the first and second light conversion structures need not be congruent to one another or of the same thickness. Finally, from a fabrication standpoint, the first and second light conversion structures **200, 600** may be fabricated and then attached to one another before attaching the assembly of the first and second light conversion structures **200/600** to the solid state light emitting die **110.** Alternatively, one of the light conversion structures may be attached to the solid state light emitting die **110** and then the other light conversion structure may be attached to the light conversion structure that is already attached to the solid state light emitting die **110.** Three or more light conversion structures also may be used in other embodiments of the present invention.

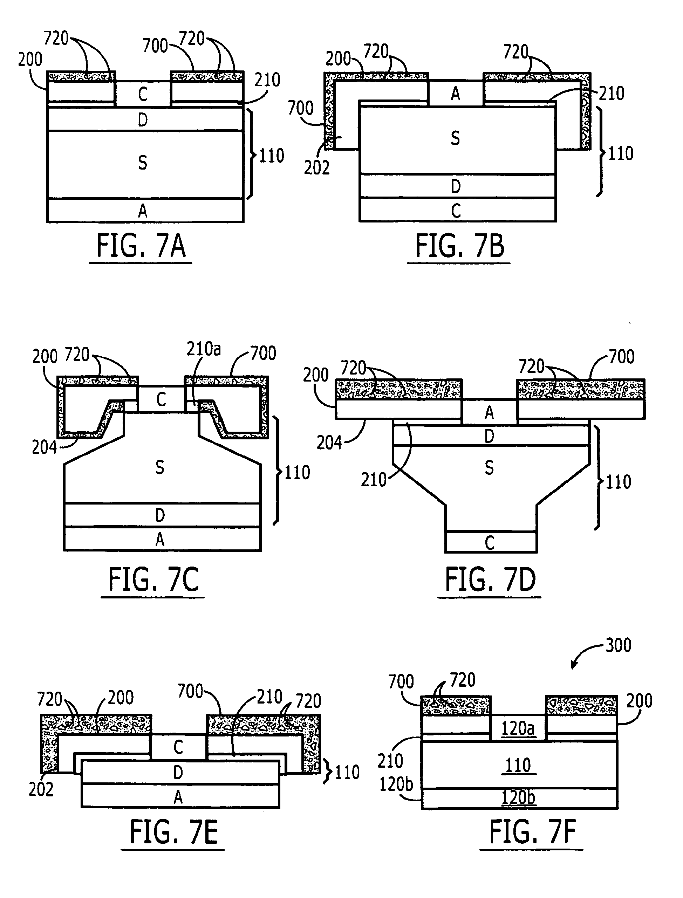

As another example, embodiments that are illustrated in Figures 7A-7F provide an optical element, such as polycrystalline phosphor particles **720,** on the single crystal phosphor light conversion structure **200.** The coating may be provided by coating a single crystal phosphor light conversion structure at any point during its fabrication and then by attaching a coated single crystal phosphor light conversion structure to the solid state light emitting die. However, in other embodiments, coating may be performed after the single crystal phosphor light conversion structure is attached to the die.

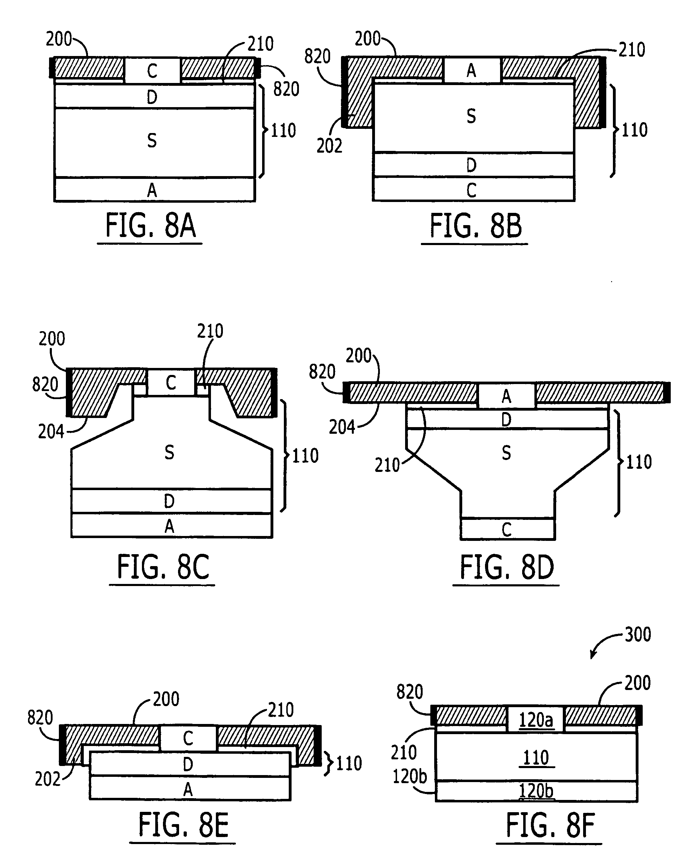

Figures 8A-8F illustrate other embodiments of the present invention, wherein a reflector **820** is provided on the single crystal phosphor light conversion structure **200,** for example on a sidewall of the single crystal phosphor light conversion structure **200.** The reflector **820** may change the radiation pattern of the light emitting die by reflecting stray side radiation back into a main radiation path. The reflector **820** may be created by selectively metallizing the single crystal phosphor light conversion structure **200** before attachment to the solid state light emitting die. In other embodiments, the single crystal phosphor light conversion structure **200** may be metallized after it is attached. It will be understood that mirrors and/or other reflectors **820** may be combined with any of the other embodiments described herein. It will also be understood that the metallization also may be used to provide electrical traces, wiring and/or contacts, so as to provide an electrical element in and/or on the single crystal phosphor light conversion structure.

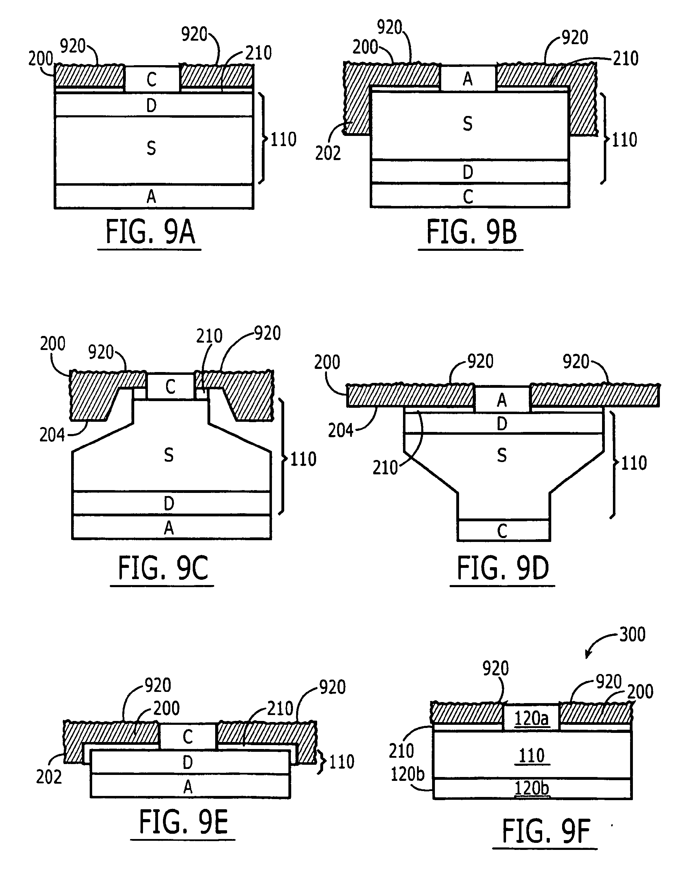

Figures 9A-9F illustrate other embodiments of the present invention, wherein the optical element is a diffuser **920** that is formed by texturing a surface of the single crystal phosphor light conversion structure **200.** The relative rigidity of the single crystal phosphor may facilitate the effective texturization of the surface. Etching, molding, sandblasting and/or other techniques for texturing are well known to those having skill in the art. As is also well known, texturing can provide diffusion of emitted radiation that can allow more uniform CCT. It will also be understood that texturing may be provided on a separate single crystal phosphor light conversion structure, and may be combined with any of the other embodiments of the invention that are described herein. Moreover, rather than texturing **820,** a die-scale lens and/or an array of microlenses also may be provided on the surface of the single crystal phosphor light conversion structure **200,** to provide further optical processing.

It will be understood by those having skill in the art that the surface of a solid state light emitting die itself may be textured by etching the semiconductor material. Unfortunately, this etching may decrease the yield and/or reliability of the solid state light emitting die. In sharp contrast, embodiments of the present invention can texture a separate single crystal phosphor light conversion structure using conventional etching techniques, and then use this textured single crystal phosphor light conversion structure to reduce or obviate the need to texture the solid state light emitting die itself.

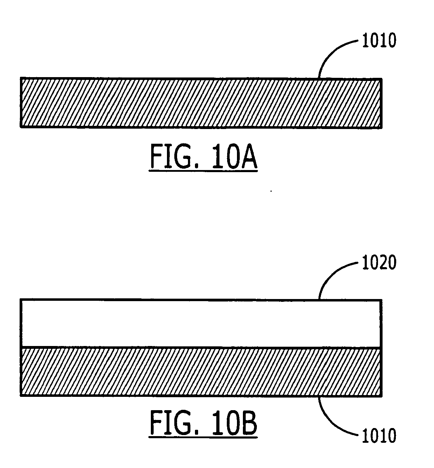

Figures 10A and 10B illustrate some embodiments of the invention wherein a single crystal phosphor light conversion structure provides a substrate for the epitaxial growth of a solid state light emitting die. Figure 10A depicts a single crystal phosphor light conversion structure **1010** according to some embodiments of the invention. As with other embodiments of the invention, any suitable single crystal phosphor material may be used, including the specific phosphor materials described herein. Figure 10B depicts the single crystal phosphor light conversion structure **1010** acting as a substrate for the solid state light emitting die **1020.** Any suitable solid state light emitting material may be used, but in some embodiments, Group III nitrides, such as GaN or InGaN, and in some embodiments, materials such as ZnO or GaP, may be used. As with other embodiments described herein, many different configurations may be used, and the configurations may be used in combination with other optical elements, such as the optical elements described herein. These embodiments can use the single crystal phosphor layer **1010** as a substrate for the epitaxial growth of the solid state light emitting die **1020.** In some embodiments, one or more buffer layers may be provided therebetween. Moreover, in some embodiments, the phosphor layer itself may be formed on another layer or substrate.

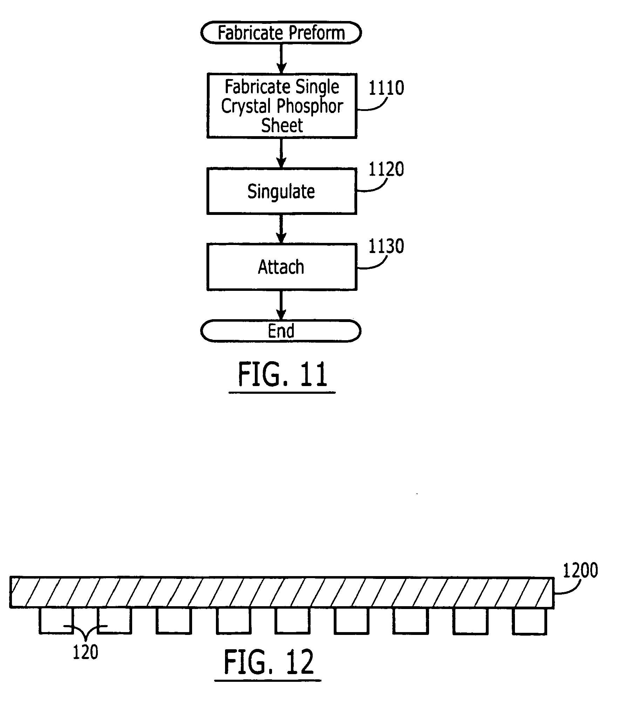

Figure 11 is a flowchart of operations that may be performed to fabricate a single crystal phosphor light conversion structure, according to various embodiments of the present invention, which may correspond to Block **420** of Figure 4. As shown at Block **1110,** a single crystal phosphor sheet is fabricated, *e.g.*, by a Czochralski-type method. A Czochralski-type method is a method of producing large single crystals, or boules, by inserting a small seed crystal of an inorganic material into a crucible filled with similar molten material, then slowly pulling the seed up from the melt while rotating it. In some embodiments, the single crystal phosphor sheet may be grown on a carrier substrate, such as a glass substrate.

Referring back to Figure 11, at Block **1120,** the single crystal phosphor sheet is singulated to form individual single crystal phosphor light conversion structures. In some embodiments, the single crystal phosphor sheet is singulated, but an attached substrate is not singulated, while in other embodiments, both the single crystal phosphor sheet and the attached substrate are singulated. The single crystal phosphor light conversion structure may be removed from the substrate using a pick and place and/or conventional mechanism, and attached to the solid state light emitting die, as shown in Block **1130.** Some embodiments of the present invention can allow mass production of light conversion structures which due to their rigidity may be handled by automated equipment.

As was described above, in some embodiments, the single crystal phosphor light conversion structures may be planar and may be the same size and shape as a surface of the light emitting die. In other embodiments, the single crystal phosphor light conversion structures may be laser or saw cut into a desired shape, to provide, for example, wire bond notches in a square single crystal phosphor light conversion structure and/or to allow the single crystal phosphor light conversion structure to fit on and around the die surface. In other embodiments, desired shapes may be formed by etching a single crystal phosphor light conversion structure after it is formed. Moreover, in some embodiments, three-dimensional preforms may be fabricated that can provide single crystal phosphor light conversion structures having a shallow cup shape to allow edge of the die coverage by the single crystal phosphor light conversion structure, with appropriate cutouts for wire bonds and/or other features. Moreover, the single crystal phosphor light conversion structures may have varying thickness, to match the light intensity of the LED, which can increase or maximize the uniformity of light conversion, and thereby provide more uniform illumination.

Embodiments of the present invention have been described above in connection with a single crystal phosphor light conversion structure that is a preform that is adhesively attached to a single LED. However, in other embodiments, as illustrated in Figure 12, large single crystal phosphor preform sheets **1200** could be used to adhesively attach multiple LED dice **120** in large fixtures. The type of single crystal phosphor and the thickness of the sheets **1200** may be altered to make different temperatures of white light, depending on which sheets are used. Different types of light, such as morning sunlight, noonday sunlight, evening light and/or other colors, may then be provided, by changing or adding/subtracting phosphor sheets for emission control.

As described above, instead of the single crystal phosphor single crystal phosphor light conversion structures **200** grown externally, in some embodiments of the invention, a single crystal phosphor single crystal phosphor light conversion structure **200** may be grown on a light emitting surface of a solid state light emitting die. The term "grown," as used herein, refers to the formation of a single crystal phosphor thin film via any single crystal thin film deposition technique, such as metal organic chemical vapor deposition (MOCVD), molecular beam epitaxy (MBE), low pressure deposition (LPD), and any other single crystal thin film deposition technique known to those of skill in the art.

As with the single crystal phosphor preforms, LEDs including a single crystal phosphor grown directly on the light emitting die may be in many different configurations. For example, any of the configurations illustrated in Figures 3A-3N may be produced by growing a single crystal phosphor single crystal phosphor light conversion structure on the solid state light emitting die. In addition, the configurations shown in Figures 5A and 5B could also be achieved by using a single crystal phosphor thin film deposition technique. For example, referring to Figure 5A, a sacrificial layer or other support structure could be provided in the submount **130** in order to allow for the growth of the single crystal phosphor layer. As another example, referring to Figure 5B, a single crystal phosphor may be grown on the transparent substrate **500,** or as with Figure 5A, a support layer could be provided for the growth of the single crystal phosphor. Referring to Figures 3A-3N, in some embodiments, the single crystal phosphors may be grown directly on the surface of the die **110.** Thus, the coupling/adhesive layer **210** may not necessarily be present in the LED, but in some embodiments, the coupling/adhesive layer **210** could be present, particularly to provide a layer through which a low profile wire bond **334** may be passed through. In addition, in some embodiments, selective growth of the single crystal phosphor single crystal phosphor light conversion structure **200** may be achieved via masking techniques known to those of skill in the art. Furthermore, in some embodiments, a blanket single crystal phosphor may be grown, and then subsquently etched, to provide voids, holes or other features, to the single crystal phosphor single crystal phosphor light conversion structure **200.** Also according to some embodiments, a support layer and/or a sacrificial layer may be formed on or adjacent to the solid state light emitting die **110** in order to support the formation of various shapes and configurations of single crystal phosphor light conversion structures **200.** It will also be understood that masking and etching processes may be used in combination.

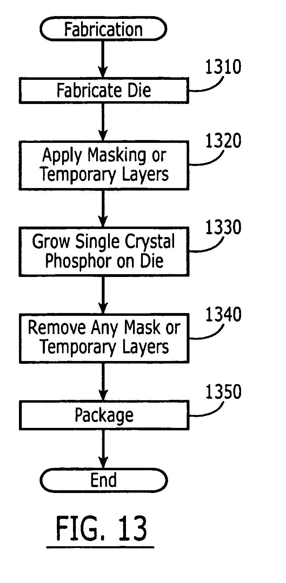

Figure 13 is a flowchart of operations that may be performed to fabricate solid state light emitting devices according to embodiments of the present invention. Referring to Figure 13, at Block **1310,** the solid state light emitting die, such as the die **110,** is fabricated using conventional techniques. At Block **1320,** a mask, a coupling layer, a and/or a temporary layer (such as a sacrificial layer or support layer) may, in some embodiments, be formed on and/or adjacent to the solid state light emitting die. For example, in embodiments illustrated in Figures 3A-3G, the anode or cathode may be masked so as to allow the formation of the single crystal phosphor light conversion structure on the die **110** but not the contact **120a.** In addition, configurations such as those depicted in Figures 3B, 3C, 3D 3F, 3I, 3J, 3K and 3L may require temporary supports or sacrificial layers on and/or adjacent to the die **110** in order to provide support for the formation of nonplanar and/or overhanging single crystal phosphor light conversion structures. Referring to Block **1330,** a single crystal phosphor may be grown on a surface of the die **110.** Removal of a mask, a support layer and/or a sacraficial layer may occur in some embodiments at Block **1340.** Subsequent packaging may then take place at Block **1350,** for example, by bonding the unitary structure of the die **110** and the single crystal phosphor light conversion structure **200** to a submount and/or other packaging substrate. It will also be understood that a wire bond may be attached to the die before or after depositing step at Block **1330.**

As with the single crystal phosphor light conversion structures grown externally, many other optical elements may be provided in combination with single crystal phosphor light conversion structures that are grown directly on the surface of the light emitting die. All of the optical elements and combinations described with reference to single crystal phosphor light conversion structures grown externally (preforms) may also be used with single crystal phosphor light conversion structures grown on the solid state light emitting die, including light conversion structures comprising scattering particles, as illustrated in Figures 6A-6F; polycrystalline phosphor particle coatings, as illustrated in Figures 7A-7F; reflectors, as illustrated in Figures 8A-8F; and diffusing elements, as illustrated in Figures 9A-9F.

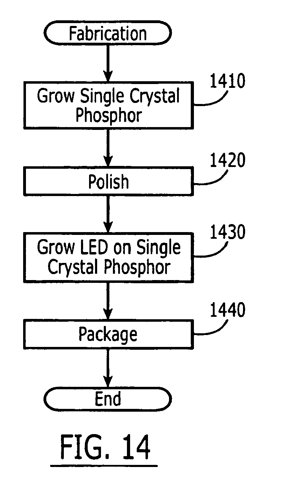

Figure 14 is a flowchart of operations that may be performed to fabricate solid state light emitting devices according to other embodiments of the present invention. Referring to Figure 14, at Block **1410,** a single crystal phosphor may be grown using any suitable technique, such as by any of the techniques described herein. In some embodiments, the single crystal phosphor is grown on another layer or substrate. Moreover, in some embodiments, the single crystal phosphor may be grown on one substrate and transferred to another substrate for further processing. At Block **1420,** the single crystal phosphor may then be polished, *e.g.*, by using a polishing technique known in art for polishing single crystals and/or other inorganic layers. At Block **1430,** a solid state light emitting die may then be epitaxially grown on the single crystal phosphor. Any suitable technique for growing the solid state light emitting die may be used. For example, techniques for growing Group III nitrides, such as GaN or InGaN, on the single crystal phosphor may be similar to those used in growing Group III nitrides on other substrates such as silicon, silicon carbide and sapphire. Particular techniques may be similar to those described in United States Patent Nos. 7,211,833, 7,170,097, 7,125,737, 7,087,936, 7,084,436, 7,042,020, 7,037,742, 7,034,328 and 7,026,659, the contents of each of which are incorporated herein by reference in their entirety. In some embodiments, one or more buffer layers are provided on the single crystal phosphor before the solid state light emitting die is epitaxially grown thereon. At Block **1440,** the resulting solid state light emitting device may be packaged, which may include, *e.g.*, singulation of the solid state light emitting die grown on the single crystal phosphor.

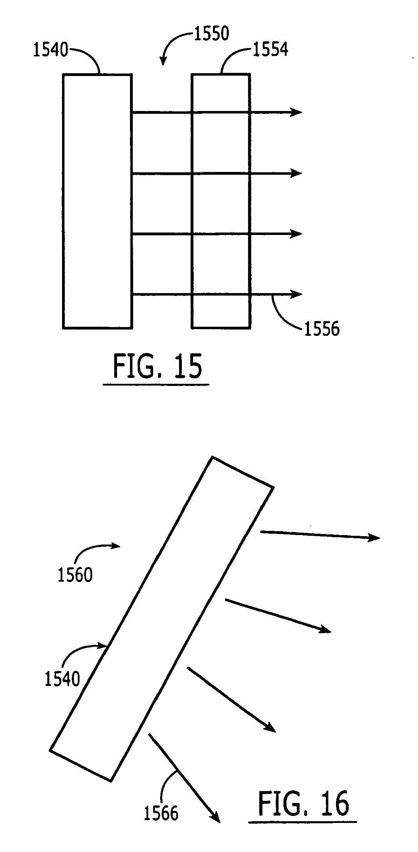

The light emitting devices provided according to some embodiments of the invention may be used in many applications. For example, referring to Figure 15, a lighting panel **1540** including a plurality of light emitting devices according to some embodiments of the invention may be used as a backlight for a display such as a liquid crystal display (LCD) **1550.** Systems and methods for controlling solid state backlight panels are described, for example, in U.S. Patent Application Ser. No. 11/368,976, filed March 6, 2006 entitled *Adaptive Adjustment of Light Output of Solid State Lighting Panels*, which is assigned to the assignee of the present invention and the disclosure of which is incorporated herein by reference in its entirety. As shown in Figure 15, an LCD **1550** may include a lighting panel **1540** that is positioned relative to an LCD screen **1554** such that light **1556** emitted by the lighting panel **1540** passes through the LCD screen **1554** to provide backlight for the LCD screen **1554.** The LCD screen **1554** includes appropriately arranged shutters and associated filters that are configured to selectively pass/block a selected color of light **1556** from the lighting panel **1540** to generate a display image. The lighting panel **1540** may include a plurality of light emitting devices according to any of the embodiments described herein.

As an additional example, referring to Figure 16, a lighting panel **1540** including a plurality of light emitting devices according to some embodiments of the invention may be used as a lighting panel for a solid state lighting fixture or luminaire **1360.** Light **1566** emitted by the luminaire **1560** may be used to illuminate an area and/or an object. Solid state luminaires are described, for example, in U.S. Patent Application Ser. No. 11/408,648, filed April 21, 2006, entitled *Solid State Luminaires for General Illumination,* which is assigned to the assignee of the present invention and the disclosure of which is incorporated herein by reference in its entirety.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

In the drawings and specification, there have been disclosed embodiments of the invention and, although specific terms are employed, they are used in a generic and descriptive sense only and not for purposes of limitation, the scope of the invention being set forth in the following claims.

## Claims

1. A solid state light emitting device comprising:
a solid state light emitting die (110) that is configured to emit light upon energization thereof; and
a light conversion structure (200) consisting of a single crystal phosphor on a light emitting surface of the solid state light emitting die.

2. The solid state light emitting device of claim 1, wherein the light conversion structure is attached to the light emitting surface via an adhesive layer.

3. The solid state light emitting device of claim 2, wherein the light conversion structure is sized to fit the light emitting surface of the solid state light emitting die.

4. The solid state light emitting device of claim 1, wherein the single crystal phosphor comprises cerium or europium.

5. The solid state light emitting device of claim 4, wherein the single crystal phosphor comprises Y₃Aℓ₅O₁₂ doped with Ce³⁺ (Ce:YAG), CaₓSr_{y}Mg_{1-x-y} AℓSiN₃ doped with cerium or strontium thio-gallate doped with cerium.

6. The solid state light emitting device of claim 4, wherein the single crystal phosphor comprises Sr₂₋ₓBaₓSiO₄ doped with Eu²⁻ (BOSE), CaxSr₁₋ₓAlSiN₃ doped with europium, strontium thio-gallate doped with europium, alpha-SiAlON doped with europium, silicon garnet doped with europium, Y₂O₂S doped with europium or La₂O₂S doped with europium.

7. The solid state light emitting device of claim 1, wherein the surface of the single crystal phosphor is texturized, roughened, etched and/or featured.

8. The solid state light emitting device of claim 1, wherein the light conversion structure is directly on the light emitting surface of the solid state light emitting die.

9. The solid state light emitting device of claim 1, wherein the light conversion structure acts as a substrate for the solid state light emitting die.

10. The solid state light emitting device of claim 1, wherein the single crystal phosphor has a thickness in a range of about 10 nm to about 200 µm.

11. The solid state light emitting device of claim 1, wherein the light conversion structure comprises a sidewall or overhang.

12. A method of fabricating a solid state light emitting device according to any preceding claim comprising: placing a light conversion structure consisting of a single crystal phosphor on a light emitting surface of a solid state light emitting die.

13. The method of claim 12, wherein placing the light conversion structure on the light emitting surface comprises growing a single crystal phosphor on the surface of the solid light emitting die via a thin film deposition technique.

14. A method of fabricating a solid state light emitting device comprising growing a solid state light emitting die on a surface of a light conversion structure (200) that consists of single crystal phosphor.

15. The method of claim 14, wherein the surface of the light conversion structure is polished before the solid state light emitting die is grown thereon.

## Patentansprüche

1. Festzustand-Lichtemissionsvorrichtung umfassend:
einen Festzustand-Lichtemissionschip (110), der konfiguriert ist, um bei dessen Anregung Licht zu emittieren; und
eine aus monokristallinem Phosphor bestehende Lichtumwandlungsstruktur (200) auf einer Lichtemissionsoberfläche des Festzustand-Lichtemissionschips.

2. Die Festzustand-Lichtemissionsvorrichtung von Anspruch 1, worin die Lichtumwandlungsstruktur über eine Haftschicht an der Lichtemissionsoberfläche angebracht ist.

3. Die Festzustand-Lichtemissionsvorrichtung von Anspruch 2, worin die Lichtumwandlungsstruktur passend zur Lichtemissionsoberfläche des Festzustand-Lichtemissionschips bemessen ist.

4. Die Festzustand-Lichtemissionsvorrichtung von Anspruch 1, worin das monokristalline Phosphor Cerium oder Europium aufweist.

5. Die Festzustand-Lichtemissionsvorrichtung von Anspruch 4, worin das monokristalline Phosphor mit Ce³⁺ dotiertes Y₃Al₅O₁₂ (Ce:YAG), CaₓSr_{y}Mg_{1-x-y}AlSiN₃ oder mit Cerium dotiertes Strontiumthiogallat aufweist.

6. Die Festzustand-Lichtemissionsvorrichtung von Anspruch 4, worin das monokristalline Phosphor mit Eu²⁻ dotiertes Sr₂₋ₓBaₓSiO₄ (BOSE), mit Europium dotiertes CaₓSr₁₋ₓAlSiN₃, mit Europium dotiertes Strontiumthiogallat, mit Europium dotiertes alpha-SiAlON, mit Europium dotiertes Silizium-Granat, mit Europium dotiertes Y₂O₂S oder mit Europium dotiertes La₂O₂S aufweist.

7. Die Festzustand-Lichtemissionsvorrichtung von Anspruch 1, worin die Oberfläche des monokristallinen Phosphors texturisiert, aufgeraut, geätzt und/oder gekennzeichnet ist.

8. Die Festzustand-Lichtemissionsvorrichtung von Anspruch 1, worin sich die Lichtumwandlungsstruktur direkt auf der Lichtemissionsoberfläche des Festzustand-Lichtemissionschips befindet.

9. Die Festzustand-Lichtemissionsvorrichtung von Anspruch 1, worin die Lichtumwandlungsstruktur als Substrat für den Festzustand-Lichtemissionschip wirkt.

10. Die Festzustand-Lichtemissionsvorrichtung von Anspruch 1, worin das monokristalline Phosphor eine Dicke im Bereich von etwa 10nm bis etwa 200µm hat.

11. Die Festzustand-Lichtemissionsvorrichtung von Anspruch 1, worin die Lichtumwandlungsstruktur eine Seitenwand oder einen Überhang aufweist.

12. Verfahren der Herstellung einer Festzustand-Lichtemissionsvorrichtung nach einem vorangehenden Anspruch, umfassend: Anordnen einer aus monokristallinem Phosphor bestehenden Lichtumwandlungsstruktur auf einer Lichtemissionsoberfläche eines Festzustand-Lichtemissionschips.

13. Das Verfahren von Anspruch 12, worin das Anordnen der Lichtumwandlungsstruktur auf der Lichtemissionsoberfläche umfasst:
Wachsen von monokristallinem Phosphor auf der Oberfläche des Festzustand-Lichtemissionschips durch eine Dünnfilmabscheidungstechnik.

14. Verfahren der Herstellung einer Festzustand-Lichtemissionsvorrichtung, umfassend: Wachsen eines Festzustand-Lichtemissionschips auf einer Oberfläche einer Lichtumwandlungsstruktur (200), die aus monokristallinem Phosphor besteht.

15. Das Verfahren von Anspruch 14, worin die Oberfläche der Lichtumwandlungsstruktur poliert wird, bevor der Festzustand-Lichtemissionschip darauf wächst.

## Revendications

1. Dispositif à semi-conducteur émettant de la lumière comprenant :
une puce à semi-conducteur (110) émettant de la lumière qui est configurée pour émettre de la lumière lorsqu'elle est mise sous tension ; et
une structure (200) de conversion de la lumière composée d'un phosphore monocristallin sur une surface émettant de la lumière de la puce à semi-conducteur émettant de la lumière.

2. Dispositif à semi-conducteur émettant de la lumière de la revendication 1, dans lequel la structure de conversion de la lumière est fixée à la surface émettant de la lumière par l'intermédiaire d'une couche adhésive.

3. Dispositif à semi-conducteur émettant de la lumière de la revendication 2, dans lequel la structure de conversion de la lumière est dimensionnée pour s'ajuster à la surface émettant de la lumière de la puce à semi-conducteur émettant de la lumière.

4. Dispositif à semi-conducteur émettant de la lumière de la revendication 1, dans lequel le phosphore monocristallin comprend du cérium ou de l'europium.

5. Dispositif à semi-conducteur émettant de la lumière de la revendication 4, dans lequel le phosphore monocristallin comprend le Y₃Al₅O₁₂ dopé au Ce³⁺ (Ce:YAG), le CaₓSr_{y}Mg_{1-x-y} AlSᵢN₃ dopé au cérium ou le thio-gallate de strontium dopé au cérium.

6. Dispositif à semi-conducteur émettant de la lumière de la revendication 4, dans lequel le phosphore monocristallin comprend le Sr₂₋ₓBaₓSiO₄ dopé à l'Eu²⁻ (BOSE), le CaₓSr₁₋ₓAlSiN₃ dopé à l'europium, le thio-gallate de strontium dopé à l'europium, l'alpha-SiAlON dopé à l'europium, le grenat de silicium dopé à l'europium, le Y₂O₂S dopé à l'europium ou le La₂O₂S dopé à l'europium.

7. Dispositif à semi-conducteur émettant de la lumière de la revendication 1, dans lequel la surface du phosphore monocristallin est texturée, rugueuse, gravée et/ou présente une particularité.

8. Dispositif à semi-conducteur émettant de la lumière de la revendication 1, dans lequel la structure de conversion de la lumière se trouve directement sur la surface émettant de la lumière de la puce à semi-conducteur émettant de la lumière.

9. Dispositif à semi-conducteur émettant de la lumière de la revendication 1, dans lequel la structure de conversion de la lumière agit comme un substrat pour la puce à semi-conducteur émettant de la lumière.

10. Dispositif à semi-conducteur émettant de la lumière de la revendication 1, dans lequel le phosphore monocristallin a une épaisseur qui se dans une plage comprise entre environ 10 nm et environ 200 µm.

11. Dispositif à semi-conducteur émettant de la lumière de la revendication 1, dans lequel la structure de conversion de la lumière comprend une paroi latérale ou une saillie.

12. Procédé de fabrication d'un dispositif à semi-conducteur émettant de la lumière selon l'une des revendications précédentes comprenant le fait : de placer une structure de conversion de la lumière constituée d'un phosphore monocristallin sur une surface émettant de la lumière d'une puce à semi-conducteur émettant de la lumière.

13. Procédé de la revendication 12, dans lequel le fait de placer la structure de conversion de la lumière sur la surface émettant de la lumière comprend la croissance d'un phosphore monocristallin sur la surface de la puce à semi-conducteur émettant de la lumière par l'intermédiaire d'une technique de dépôt en couches minces.

14. Procédé de fabrication d'un dispositif à semi-conducteur émettant de la lumière comprenant la croissance d'une puce à semi-conducteur émettant de la lumière sur une surface d'une structure de conversion de la lumière (200) qui se compose du phosphore monocristallin.

15. Procédé de la revendication 14, dans lequel la surface de la structure de conversion de la lumière est polie avant de faire croître dessus la puce à semi-conducteur émettant de la lumière.
